Europäisches Patentamt

European Patent Office

Office européen des brevets

(19)

(11) Veröffentlichungsnummer: **0 238 869**
**A2**

(12) # EUROPÄISCHE PATENTANMELDUNG

(21) Anmeldenummer: **87102588.8**

(22) Anmeldetag: **24.02.87**

(51) Int. Cl.4: **H03H 2/00** , H03F 3/55 , H01P 9/00

(30) Priorität: **19.03.86 DE 3609231**

(43) Veröffentlichungstag der Anmeldung:
**30.09.87 Patentblatt 87/40**

(84) Benannte Vertragsstaaten:
**AT BE CH DE ES FR GB GR IT LI NL SE**

(71) Anmelder: **Siemens Aktiengesellschaft Berlin
und München
Wittelsbacherplatz 2
D-8000 München 2(DE)**

(72) Erfinder: **Edenhofer, Peter, Dr.Prof.
Brandstrasse 2
D-8000 München 21(DE)**

(54) **Mikrowellen-Bauelement mit gekoppelten Schichten aus magnetisierbarem Material und aus Halbleitermaterial.**

(57) Elektronisches Bauelement mit einem Sandwich-Aufbau (1) aus zwei magnetisierbaren Schichten (2, 4) und einer Halbleiterschicht (6). In den magnetisierbaren Schichten (2, 4) werden magnetostatische Oberflächenwellen (MSSW) mittels Wandler (11, 111) erzeugt, die aufgrund der Bemessungen angenähert gleich große Phasengeschwindigkeit haben wie die Ladungsträgerströmung zwischen den Elektroden (12) in der Halbleiterschicht (6). Das Bauelement (1) ist je nach Betriebsweise als Verstärker oder als passives Bauelement für den Mikrowellenbereich zu verwenden.

FIG 1

EP 0 238 869 A2

## Mikrowellen-Bauelement mit gekoppelten Schichten aus magnetisierbarem Material und aus Halbleitermaterial

Die vorliegende Erfindung bezieht sich auf ein Mikrowellen-Bauelement wie im Oberbegriff des Patentanspruches 1 angegeben.

Aus AEÜ, Bd. 39 (1985). S. 77 - 86 sind Untersuchungen an einem geschichteten Substrat bekannt, das Yttrium-Eisengranat-(YIG-)Material, Halbleitermaterial und gegebenenfalls (weiteres) dielektrisches Material umfaßt. Dieses Substrat ist mit einer darauf aufgebrachten Streifenleitung versehen worden, mit der in dem Substrat magnetostatische Oberflächenwellen erzeugt worden sind. Bezüglich magnetostatischer Oberflächenwellen (MSSW) sei auch auf Electronic Letters, Bd. 15 (1979), S. 172 - 174 hingewiesen, wo unter anderem gekoppelte magnetische Schichten erörtert sind.

In der Druckschrift AEÜ ... sind nähere Einzelheiten hinsichtlich der Verkoppelung zwischen vorgesehenen Strahlerelementen und der Oberflächenwelle angegeben. Es ist dort auch auf die Verstärkung magnetostatischer Oberflächenwellen hingewiesen. Weiter findet sich dort ein Hinweis auf die Möglichkeit eines aktiven Arrays, bei dem man eine mit langsamer Phasengeschwindigkeit laufende Oberflächenwelle und in der Halbleiterschicht driftende Elektronen in Wechselwirkung miteinander treten läßt. Bild 16 der Druckschrift AEÜ ... zeigt einen Aufbau für eine aktive planare Strahleranordnung mit einem YIG-Kristall, mit einem Aluminiumoxid-Substrat mit Galliumarsenid als Substrat und als leitfähiger Film und mit Streifenleitungen (Strahlerelementen). Eine technische Verwertung einer solchen bekanntgewordenen Anordnung ist nicht erfolgt.

Es ist eine Aufgabe der vorliegenden Erfindung, technische Maßnahmen anzugeben, mit denen der obige Vorschlag zu einem technisch vorteilhaften elektronischen Bauelement umzusetzen ist, wobei es sich bei diesem Bauelement nicht nur um einen Verstärker, sondern auch um ein passives Bauelement handeln kann, geeignet z.B. als Phasenschieber, Verzögerungsleitung, Filter und dgl..

Diese Aufgabe wird mit einem elektronischen Bauelement mit den Merkmalen des Patentanspruches 1 gelöst und weitere Ausgestaltungen und Weiterbildungen der Erfindung gehen aus den Unteransprüchen hervor.

Die Erfindung beruht auf einer erst zwischenzeitlich gewonnenen Erkenntnis. Es ist eine Art Sandwich-Anordnung vorgesehen, die aus (jeweils) zwei Schichten aus magnetisierbarem Material und einer dazwischen befindlichen Halbleiterschicht besteht. Zusätzlich kann eine dielektrische Schicht zwischen (jeweils) der einen magnetisierbaren Schicht und der der halbleitenden Schicht vorgesehen sein. Als Material für die magnetisierbare Schicht kommen das schon erwähnte Yttrium-Eisengranat, dieses insbesondere auch substituiert, und dgl. in Betracht, und zwar solches Material, das eine relative Permeabilitätskonstante $\mu_r$ größer als 1 hat und bei dem die Größe des Wertes $\mu_r$ mit einem transversal zur vorgesehenen Wellenausbreitungsrichtung orientierten, eingeprägten magnetostatischen Feld variierbar ist. Als Halbleitermaterial kommen III-V-Halbleitermaterial, insbesondere das schon erwähnte Gallium arsenid und auch Silizium in Betracht. Vorteilhaft ist solches Halbleitermaterial, das eine ausgeprägte n- bzw. p-Leitfähigkeit mit (für Halbleitermaterial) relativ hoher Ladungsträger-Beweglichkeit bei geringer Eigenleitfähigkeit besitzt. Ein solches Halbleiter-"Material" kann auch ein solches mit einem Übergitter, einer Hetero-Schichtstruktur (z.B. Galliumarsenid/Gallium-Aluminiumarsenid/...), einer npnp... bzw. nipinip...-Struktur und dgl. sein. Hierfür ist bekannt, daß relativ hohe Ladungsträgerbeweglichkeit vorliegt.

Gemäß einem weiteren Merkmal der Erfindung sind die beiden Schichten aus magnetisierbarem Material und die Halbleiterschicht in räumlicher Nähe, d.h. direkt oder nicht-unmittelbar, aufeinanderliegend. Als schon erwähnte Zwischenschicht kann dielektrisches Material wie Aluminiumoxid und entsprechendes Material, eine dielektrische Kunststoffolie und dgl. vorgesehen sein.

Es ist darauf hinzuweisen, daß insbesondere für die Halbleiterschicht eine Schichtdicke von vorzugsweise nur bis zu 10 $\mu$m vorzusehen ist und auch eine ggf. vorgesehene Zwischenschicht nur entsprechend geringe Dicke hat. Dies deshalb, damit die (jeweils) zwei Schichten aus magnetisierbarem Material, z.B. aus Yttrium-Eisengranat, in der Sandwich-Anordnung nicht zu großen Abstand voneinander haben, damit die Wechselwirkung zwischen diesen magnetisierbaren Schichten noch ausreichend groß ist.

Auch die Schichten aus dem magnetisierbarem Material, z.B. dem Yttrium-Eisengranat, haben relativ geringe Dicke zwischen z.B. 5 bis 30, vorzugsweise um 20 $\mu$m. Bekanntlich können solche Yttrium-Eisengranat-Schichten auf einem Substrat aus Gallium-Gadolinium-Granat (GGG) epitaktisch abgeschieden werden. Dieses Material hat z.B. keinen störenden Einfluß auf die Funktionsweise des erfindungsgemäßen elektronischen Bauelementes, d.h. auf die Wechselwirkung zwischen den magnetisierbaren Schichten untereinander und den magnetisierbaren Schichten mit der Halbleiterschicht.

An entsprechender Stelle befindet sich auf der jeweiligen Schicht aus magnetisierbarem Material eine Wandler-Anordnung, die der an sich bekannten Anregung mit in vorgegebener Wellenausbreitungsrichtung laufender magnetostatischer Oberflächenwelle (MSSW). Es wurde festgestellt, daß bei einer wie angegebenen Dicke der jeweiligen Schichten aus dem magnetisierbaren Material und der angegebenen Anordnung eines Paares solcher Schichten derjenige Typ, sog. Typ I, einer MSSW-Welle zumindest wesentlich bevorzugt anzuregen ist, der den Vorteil besonders geringer Phasengeschwindigkeit in solcher Größe hat, wie sie als Geschwindigkeit von Ladungsträgern in Halbleitermaterial (mit wie oben angegebener hoher Ladungsträgerbeweglichkeit) zu erreichen ist. Mit dieser Konstellation läßt sich synchroner bzw. nahezu synchroner Lauf von magnetostatischer Oberflächenwelle und Ladungsträgerströmung im Halbleitermaterial erreichen, nämlich mit dem Ergebnis, daß von der elektrischen Ladungsträgerströmung her die Oberflächenwelle gedämpft oder verstärkt werden kann, wie dies für solche Prinzipien grundsätzlich bekannt ist.

Es ist die Anwendung eines Magnetfeldes B vorgesehen, dessen Magnetfeld-Ausrichtung in der Schicht des magnetisierbaren Materials und senkrecht zur Ladungsträgerströmung in dem Halbleitermaterial ausgerichtet ist. Mittels eines solchen statischen Magnetfeldes läßt sich eine Vormagnetisierung einstellen, durch deren größenmäßige Veränderung die Phasengeschwindigkeit der Oberflächenwelle im magnetisierbarem Material (in Grenzen) einstellbar ist.

Am Material der Halbleiterschicht sind Elektroden zur Einspeisung des elektrischen Stromes vorgesehen. Die Anordnung der Elektroden ist so getroffen, daß die vorgegebene Strömungsrichtung der Ladungsträger in der Halbleiterschicht eintritt. Vorzugsweise ist eine Steuerung der Stromstärke des in der Halbleiterschicht fließenden Stromes vorgesehen.

Von besonderem Vorteil ist ein monolithischer Aufbau des erfindungsgemäßen Bauelementes.

Weitere Erläuterungen gehen aus der nachfolgenden, anhand der Figuren gegebenen Beschreibung eines Ausführungsbeispiels hervor.

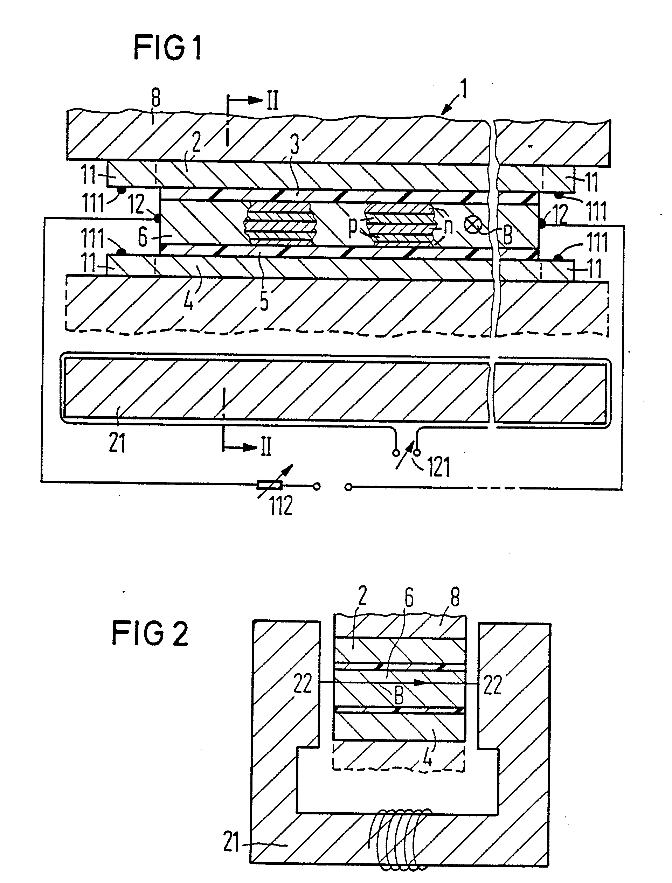

Die Figuren 1 und 2 zeigen zwei um 90° zueinander liegende Seitenansichten.

Das in den Figuren mit 1 bezeichnete elektronische Bauelement besitzt eine erste Schicht 2 aus magnetisierbarem Material (z.B. Yttrium-Eisengranat) mit einer Schichtdicke von z.B. 20 μm. Diese Schicht 2 ist auf einem Substrat 8 aus z.B.

Gallium-Gadolinium-Granat epitaktisch abgeschieden. Mit 4 ist die zweite Schicht aus magnetisierbarem Material bezeichnet, die z.B. ebenfalls auf einem Substrat abgeschieden sein kann. Die Halbleiterschicht ist mit 6 bezeichnet. In der Figur 1 ist auch ausschnittsweise eine Schicht 6 in einer Ausführungsform als Heterostruktur aus Galliumarsenid/Galliumaluminiumarsenid und ebenfalls nur ausschnittsweise in einer Ausführungsform als nipi-Struktur dargestellt. Bevorzugt besteht diese Schicht 6 aus z.B. Galliumarsenid. Die Schicht 6 hat z.B. eine Dicke von 10 μm. Mit 3 und 5 sind fakultativ vorgesehene Zwischenschichten aus z.B. Aluminiumoxid bezeichnet.

Die Wandler zur Erzeugung einer jeweiligen Oberflächenwelle auf bzw. in der Oberfläche der Schichten 2 bzw. 4 sind mit 11 bezeichnet. Diese Wandler 11 haben z.B. eine auf der Oberfläche der jeweiligen Schicht aufgebrachte Streifenstruktur 111. Diese Streifenstruktur kann auch auf der gegenüberliegenden Schicht aufgebracht oder in anderer bekannter Weise ausgeführt sein.

Mit 12 sind an der Halbleiterschicht 6 angebrachte Elektroden bezeichnet. Der Stromfluß durch die Halbleiterschicht 6 wird mit der Einrichtung 112 geregelt.

Figur 2 zeigt eine stirnseitige Ansicht zur Figur 1. Aus der Figur 2 ist die Anordnung der Einrichtung 21 zu ersehen, mit der zwischen den Polschuhen 22 das Magnetfeld erzeugt wird, das im Inneren des Bauelementes 1 wirkt. Mit 121 ist eine Einrichtung zur Regelung der erzeugten statischen Magnetfeldstärke bezeichnet.

An den, bezogen auf die Richtung der Oberflächenwelle, Enden der Schichten 2 und 4 können übliche Absorber vorgesehen sein, die mögliche Reflexionen der Welle dämpfen.

Mittels einer nicht dargestellten Kühleinrichtung kann das erfindungsgemäße Bauelement auf zweckmäßigerweise oder notwendigerweise niedrige Temperatur im Tieftemperaturbereich abgekühlt gehalten werden.

Für den Betrieb des erfindungsgemäßen aktiven oder passiven Bauelementes ist dieses in einer Anordnung einge setzt, wie sie z.B. auch aus AEÜ ... hervorgeht. Zur Signalverarbeitung können zusätzlich in den Leitungszug eingebrachte Mikrostreifenleitungsstücke in Array-Bauweise angebracht sein.

Vorteilhaft gegenüber etwa akustischen Wellen sind hier z.B. die Nichtreziprozität bei Ein-und Auskopplung, die geringe Empfindlichkeit gegenüber strukturellen Fertigungstoleranzen (infolge größerer Betriebswellenlänge) und die Einsatzmöglichkeit bis weit in den Mikrowellenbereich (ab ca. 1 GHz bis 10 GHz und sogar höher).

Bezugszeichenliste

1 Bauelement
2; 4 erste; zweite Schicht
3; 5 Zwischenschichten
6 Halbleiterschicht
8 Substrat
11 Wandler
111 Streifenleitung
12 Elektrode
112 Regeleinrichtung
21 Magneteinrichtung
22 Polschuhe
B Magnetfeld

**Ansprüche**

1. Mikrowellen-Bauelement mit magnetisierbarer Schicht und mit Halbleiterschicht, bei dem in der magnetisierbaren Schicht eine magnetostatische Oberflächenwelle (MSSW) und in der Halbleiterschicht eine Ladungsträgerströmung zu erzeugen sind, sowie ein das Bauelement zu durchsetzendes magnetostatisches Feld vorzusehen ist und wobei das vorgesehene magnetisierbare Material hochohmig bis elektrisch isolierend ist und eine relative Permeabilitätskonstante $\mu_r$ größer 1 und abhängig von einem magnetostatischen Feld hat, das transversal zur vorgesehenen Wellenrichtung orientiert ist, und das Halbleitermaterial hohe Beweglichkeit von n-bzw. p-Ladungsträgern bei geringer Eigenleitung hat, und wobei an der Schicht aus Halbleitermaterial Elektroden angeordnet sind, mit deren Hilfe eine Ladungsträgerströmung in der Schicht aus Halbleitermaterial parallel zur Haupt-Ausbreitungsrichtung der Oberflächenwelle zu erzeugen ist,
**gekennzeichnet dadurch,**
-daß ein Sandwich-Aufbau (Fig. 1 und 2) vorgesehen ist, bei dem eine erste und eine zweite Schicht (2, 4) aus dem magnetisierbaren Material vorgesehen ist und die Schicht (6) aus dem Halbleitermaterial sich zwischen dieser ersten und dieser zweiten Schicht befindet,
-daß diese erste, diese zweite Schicht (2, 4) und die Schicht (6) aus Halbleitermaterial in räumlicher Nähe übereinanderliegend angeordnet sind,
-daß die Wandleranordnung (11, 111) zur Erzeugung einer magnetostatischen (MSSW) Oberflächenwelle des Typs I bestimmt ist.

2. Bauelement nach Anspruch 1, **gekennzeichnet dadurch,** daß eine Einrichtung (21) zur Erzeugung eines magnetostatischen Feldes (B) vorgesehen ist, dessen Feldrichtung in Schichtebene (2, 4, 6) und quer zur Ladungsträgerströmung in der Schicht (6) aus halbleitendem Material gerichtet ist.

3. Bauelement nach Anspruch 2, **gekennzeichnet dadurch,** daß eine Einrichtung (121) vorgesehen ist, mittels derer das magnetostatische Feld (B) hinsichtlich seiner Magnetfeldstärke einstellbar ist.

4. Bauelement nach einem der Ansprüche 1 bis 3, **gekennzeichnet dadurch,** daß eine Einrichtung (112) zur steuerbaren Einstellung der Ladungsträgerströmung in der Schicht (6) aus Halbleitermaterial vorgesehen ist.

5. Bauelement nach einem der Ansprüche 1 bis 4, **gekennzeichnet dadurch,** daß die Dicke der Schichten (2, 4) aus dem magnetisierbaren Material zwischen 5 und 30 $\mu$m beträgt.

6. Bauelement nach einem der Ansprüche 1 bis 5, **gekennzeichnet dadurch,** daß die Dicke der Schicht (6) aus Halbleitermaterial bis zu 10 $\mu$m beträgt.

7. Bauelement nach einem der Ansprüche 1 bis 6, **gekennzeichnet dadurch,** daß zwischen der Schicht (6) aus Halbleitermaterial und einer Schicht (2, 4) aus dem magnetisierbaren Material eine Zwischenschicht (5, 7) aus dielektrischem Material vorgesehen ist.

8. Bauelement nach Anspruch 7, **gekennzeichnet dadurch,** daß eine solche Zwischenschicht (5, 7) eine Dicke von wenigen $\mu$m hat.

9. Bauelement nach einem der Ansprüche 1 bis 8, **gekennzeichnet dadurch,** daß die Schicht (6) aus Halbleitermaterial einen Hetero-Schichtstrukturaufbau besitzt.

10. Bauelement nach einem der Ansprüche 1 bis 8, **gekennzeichnet dadurch,** daß die Schicht (6) aus Halbleitermaterial den Aufbau einer nipi-Struktur besitzt.

11. Anwendung eines Bauelements nach einem der Ansprüche 1 bis 10 als passives Bauelement.

12. Anwendung eines Bauelements nach einem der Ansprüche 1 bis 10 als Verstärker.

FIG 1

FIG 2